(19) Europäisches Patentamt
European Patent Office
Office européen des brevets

(11) **EP 2 685 656 B1**

(12) **EUROPEAN PATENT SPECIFICATION**

(45) Date of publication and mention
of the grant of the patent:
**01.03.2017 Bulletin 2017/09**

(21) Application number: **12005072.9**

(22) Date of filing: **09.07.2012**

(51) Int Cl.:
**H04L 1/18** *(2006.01)*     **H03M 13/45** *(2006.01)*

(54) **Method and apparatus for dynamic soft decoding**

Verfahren und Vorrichtung zur dynamischen weichen Dekodierung

Procédé et appareil de décodage dynamique souple

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**15.01.2014 Bulletin 2014/03**

(73) Proprietor: **CommAgility Limited
Holywell Park
Loughborough LE11 3AQ (GB)**

(72) Inventor: **Turner, Jeremy
Berhampore 6023
Wellington (NZ)**

(74) Representative: **Eisenführ Speiser
Patentanwälte Rechtsanwälte PartGmbB
Postfach 31 02 60
80102 München (DE)**

(56) References cited:
**US-A1- 2005 025 076     US-A1- 2009 061 875
US-A1- 2009 185 644**

- **LIANG ZHANG ET AL: "Implementing and
optimizing a turbo decoder on a TI TMS320C64x
device", COMPUTATIONAL PROBLEM-SOLVING
(ICCP), 2011 INTERNATIONAL CONFERENCE
ON, IEEE, 21 October 2011 (2011-10-21), pages
401-404, XP032027866, DOI:
10.1109/ICCPS.2011.6092297 ISBN:
978-1-4577-0602-8**

**Description**

FIELD OF THE INVENTION

The present invention relates to a method, apparatus and computer program product for decoding binary information received via a channel of a communication system, such as - but not limited to - the long term evolution (LTE) mobile communication system which uses orthogonal frequency division multiplexing (OFDM).

BACKGROUND OF THE INVENTION

Many communication channels (including wireless channels) have characteristics that change over time, due to channel variance and random noise. Because of this, data is encoded before transmission, to increase the likelihood of being received correctly. In many modern communication systems this is done with convolutional, turbo or low density parity check (LDPC) codes, which use 'soft bit' decoders, for example the Viterbi algorithm, and turbo decoders. Due to the channel changing over time, a response (acknowledgement (ACK) or non-acknowledgement (NACK)) is typically given. Often the data can be retransmitted, e.g. using some form of (hybrid) automatic repeat request ((H)ARQ). Further details about these issues can be gathered from F.U. Dowla: "Handbook of RF and Wireless Technologies", Newnes, 2003.

In a soft bit decoder, a decoder front-end at the receiver produces a probability value for each bit in the data stream. This probability value is a measure of how likely it is that the bit is a 0 or 1 and is called "soft bit". This introduces a probabilistic aspect to the data-stream from the front end, but it conveys more information about each bit than just 0 or 1. For example, for each bit. the front end of a traditional wireless receiver decides if an internal analog voltage is above or below a given threshold voltage level. For a turbo-code decoder, the front end would provide a measure of how far the internal voltage is from this given threshold. To decode a block of data bits, the decoder front-end creates a block of likelihood measures, with one likelihood measure for each bit in the data stream. There are two parallel decoders, one for each of the parity sub-blocks. Both decoders use the sub-block of likelihoods for the payload data. The decoder working on the second parity sub-block knows the permutation that the coder used for this sub-block. Each of the two decoders generates a hypothesis (with derived likelihoods) for the bit pattern in the payload sub-block. The hypothesis bit-patterns are compared, and if they differ, the decoders exchange the derived likelihoods they have for each bit in the hypotheses. Each decoder incorporates the derived likelihood estimates from the other decoder to generate a new hypothesis for the bits in the payload. Then they compare these new hypotheses. This iterative process continues until the two decoders come up with the same hypothesis for the payload bit pattern.

When using soft bits, and retransmissions, decoding performance is greatly improved by combining the soft bits of different transmissions together. However these different transmissions can use different modulation schemes, and have different effective signal-to-noise ratios (SNR). As the value of a soft bit is related to the SNR and modulation scheme, care must be taken when combining different transmissions together to achieve optimum performance.

For example, in LTE, turbo coding is used, and the actual data to be transmitted is selected from one of four possible versions (redundancy versions) which is a form of Chase combining where every retransmission contains a subset of the same information (data and parity bits). The receiver may use maximum-ratio combining to combine the received bits with the same bits from previous transmissions. Because the data and parity bits are identical, chase combining can be seen as additional repetition coding. The Turbo decoder typically uses a fixed bit width to represent a soft bit (e.g. 4, 6, 8 bit). Using more bits in a hardware implementation requires more gates and power, but offers an increased block error ration (BER) performance. In addition, there are different turbo decoder implementations, e.g. Max-Log-MAP (Maximum A Priori) and Max-Star etc.

Typically the soft bit format is fixed at design tile along width the turbo decoder. This does not allow the use of the optimal Q format for the entire typical SNR range, which causes performance degradation. In addition, in case of retransmissions of a different modulation type, the HARQ buffer is no longer accurate.

The US 6,986,096 B2 discloses a method of scaling and quantizing soft-decision metrics for decoding, where soft metrics are calculated independently for each 'burst' (retransmission) and then 'rescaled' and added. However, this requires increased processing power and introduces complexity.

The US 2009/0185644 A1 discloses a method of producing soft-decisions values for a signal, wherein a LLR expression, which is dependent on noise power of the signal can be rendered in a form independent of the noise power. These initial soft-decision values are not scaled by noise power values, but by ratios between quality metrics. The proposed approach therefore reduces the spread in the soft-decision values, so that a reduction of the size of the memory required to store the soft-decision values can be achieved. The soft-decision values generated before and after soft-decision scaling are quantized in order to keep the number of bits required to represent them as low as possible. Typically, a fix-point notation will be employed to store these values. Hence, rounding, saturation and/or truncation is required following the multiplication of the initial soft-decision values by the scaling factor. Support of different modulation schemes can be provided by modifying the soft-decision scaling function, such that a single quality metric is output alongside the initial soft-decision values.

Additionally, the US 2005/0025076 A1 discloses a system for scaling and quantizing soft-decision metrics for decoding, wherein a scaling factor and quantization scale factor are computed based on statistics for multiple bursts transmitted at different times. The soft metrics are scaled, quantized and rescaled prior to decoding.

Finally, the US 2009/0061875 A1 discloses a method of conducting soft combining of at least two received multimedia broadcast multicast service (MBMS) signals in a user equipment of a radio telecommunications network. Buffered fix-point MBMS data vectors are scaled prior to combining them, wherein a scaling factor relating to the combined fix-point MBMS data vector is generated. The scaling factor can simply be implemented as a bit shift applied to slot data.

SUMMARY OF THE INVENTION

It is an object of the present invention to provide a soft decoding scheme with improved soft bit accuracy and improved decoder throughput.

This object is achieved by a method as claimed in claim 1, an apparatus as claimed in claim 9, and a computer program product as claimed in claim 15.

Accordingly, the predetermined bit format is selected per transmission based on the modulation type of the received signal, and the probabilities are converted into most likely transmitted bits based on the selected predetermined bit format, so that an optimal bit format (e.g. Q format) can be selected for the soft bits and applied to different parts of the decoding chain, including changing the bit format when necessary. The proposed solution allows selection of the current bit format based on e.g. both modulation type and SNR, as well as combining the retransmission buffers of different modulations. This allows for improved soft bit accuracy and improved turbo decoder throughput, leading to reduced power use, since less iterations are required to decode the data.

Furthermore, the proposed solution is flexible in both the fixed bit width of soft bits used and the type of decoder used (e.g. Max-Log-MAP or Max-Star algorithm). At the combining stage, only a single scale step needs to be done, to convert the stored bits to the current format. In addition, the soft bit decoder can be updated to support any bit format, rather than recalculating all soft bits as in the above mentioned prior art.

More specifically, decoding performance can be improved, as the proposed fractional format is closer to the optimal format. System throughput can be improved due to reduced retransmissions. Pawer consumption can be reduced due to reduced iterations in turbo or other decoders with early stopping algorithm. The proposed solution is just based on shifts to existing components and thus involves low complexity compared to conventional solutions. A scheduler is allowed to use different modulation formats in retransmission with no performance loss.

According to a first aspect, the probabilities (e.g. log likelihood ratios) may be expressed as fractional fixed point values, wherein the predetermined bit format comprises a first number of bits representing a signed integer of the fractional fixed point value and a second number of bits representing a fraction of the fractional fixed point value

According to a second aspect which may be combined with the first aspect, the predetermined bit format may also be selected based on a noise or interference estimate of the communication channel.

According to a third aspect which may be combined with any one of the first and second aspects, the predetermined bit format may be modified to map a probability of a received value of a current transmission to a stored probability of a received value of a previous transmission. This may be achieved in a retransmission combining by including a first means of bit shifting for matching the selected bit format of the previous transmission to the selected bit format of the current transmission.

According to a fourth aspect which may be combined with any one of the first to third aspects, the predetermined bit format may be modified by changing a mapping of bits onto a connection bus or by using a bit shifting process.

According to a fifth aspect which may be combined with any one of the first to fourth aspects, the probabilities may be converted to the most likely transmitted bits in the soft bit decoder by applying soft bit combining and shifting a compensation value of the soft bit combining in accordance with said selected predetermined bit format. Thereby, a change of the predetermined bit format can be compensated, when a sum value is calculated as part of the decoding process.

According to a sixth aspect which may be combined with any one of the first to fifth aspects, the received values may be converted into the probabilities by computing a function of the received value and a received noise power (which may include interference), and by shifting, e.g., by a second means of bit shifting, a bit pattern of at least one of the received value, the received noise power and an output value of the function in accordance with the selected predetermined bit format, said function being determined by a transmission scheme of the communication channel.

The above features may be implemented as hardware circuits integrated on a single chip or chip set, or wired on a circuit board. As an alternative, at least parts of the features may be implemented as a software program or routine controlling a multi-tasking processor or computer device, e.g. a software-defined radio (SDR) implementation. As an example, the software program or routine may be implemented in C type programming language.

Other advantages, modifications are defined in the dependent claims.

BRIEF DESCRIPTION OF THE DRAWINGS

The invention will now be described in greater detail based on embodiments with reference to the accompanying drawings in which:

Fig. 1 shows a schematic block diagram of soft bit processing stages in a receiver according to a first embodiment;

Fig. 2 shows a schematic block diagram of a soft demodulation stage according to the first embodiment;

Fig. 3 shows a schematic block diagram of a retransmission stage according to the first embodiment;

Fig. 4 shows a schematic flow diagram of a modified decoding procedure according to a second embodiment; and

Fig. 5 shows a schematic block diagram of a software-based implementation according to a third embodiment.

DESCRIPTION OF THE EMBODIMENTS

In the following, embodiments of the present invention will be described based on soft bit decoding in a downlink LTE receiver device.

The theoretical optimal soft bit value can be derived from the log likelihood ratio (LLR) equation. In the general case of QAM signals, the following formula can be derived for an additive white Gaussian noise (AWGN) channel:

$$LLR_I(b_k) = \ln \sum_{A \in (s:b_k=1)} \exp(-\frac{(z-A)^2}{2\sigma^2}) - \ln \sum_{B \in (s:b_k=0)} \exp(-\frac{(z-B)^2}{2\sigma^2}) \qquad (1)$$

where z is the received symbol (post equalization), A is the collection of all symbols where bit $b_k$ is 1, B is the collection of all symbols where bit $b_k$ is 0, and $\sigma^2$ is the noise power. The actual equation is dependent on the modulation format used, and this is only one example. The method to calculate the soft bit depends on the equalizer used (e.g. Maximum Ratio Combining (MRC), Minimum Means Squared error (MMSE), near Maximum Likelihood (near-ML) etc). Often, approximations are used.

The above equation (1) can be simplified with an approximation using only the closest bit with either 1 (out of the set A) or 0 (out of the set B). This approximation then gives:

$$LLR_I(b_k) \approx \min(\frac{(z-B)^2}{2\sigma^2}) - \min(\frac{(z-A)^2}{2\sigma^2}) \qquad (2)$$

The fixed soft bit value is theoretically related to the actual floating point value, but quantized into a particular bit format, which may be a "Q format" or any other bit format defining the bit structure of the soft bit value. The Q format is defined as Qm.n, where m is the number of bits representing the signed integer, and n is the number of bits representing the fraction, e.g. for 8 bit, Q0.7 (values from -1.0 to +0.992) can be used, as can Q4.3 (values from -16 to +15.875). One bit is used as the sign bit. Use of a fixed bit width leads to a fixed dynamic range.

In the following embodiments, the decision on the particular 'Q' format to use is dependent on the modulation format, and possibly the SNR. Different moduletions have different operation 'points', e.g. Quadrature Phase Shift Keying (QPSK) from -5 to +5dB, Quadrate Amplitude Modulation QAM16 from +0 to +12dB, QAM64 from +10 to +20dB. This is however just one example. The decision may depend on other parameters based on the system etc.

As the LLR formula is a function of the channel gain and noise power, the floating point soft bit of QPSK at 0dB is approx 1.0, while at 20dB is approx 100.0. This means a fixed output format for all modulation types and SNRs is not optimal.

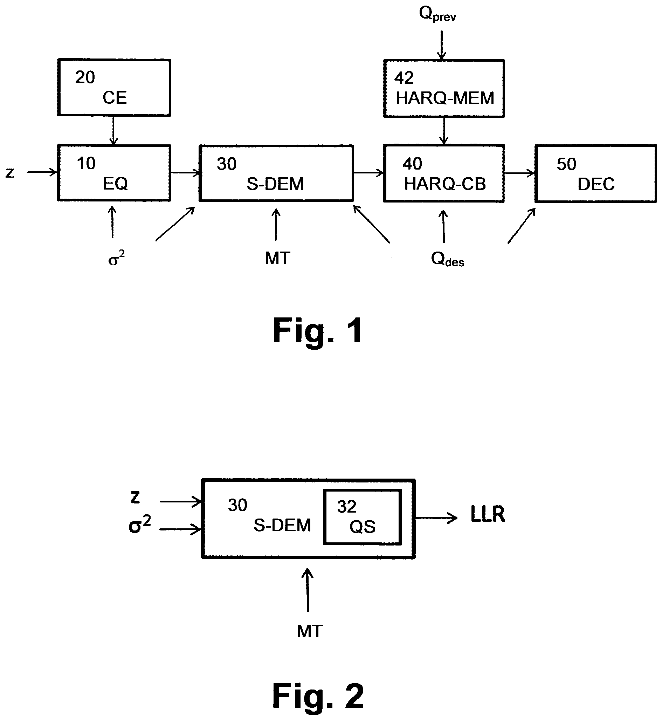

Fig. 1 shows a schematic block diagram of components or stages involved in the processing of soft bits in the LTE receiver device. Typically, in all these stages the soft bits should all be in the same format. The LTE receiver device comprises a soft demodulator (S-DEM) 30 which converts received values z (e.g. symbols or inphase (I) and/or quadrature phase (Q) samples) obtained from an equalization stage (EQ) 10 into probabilities that a bit '1' or '0' has been transmitted. The equalization stage 10 compensates for any channel frequency selectivity and thus, at least to some extent, restores the original signal shape based on characteristic channel information received from a channel estimation stage (CE) 20 and a noise power $\sigma^2$ (which may include a interference). The probabilities of the soft demodulator 30 are expressed as soft bits or soft values, wherein a desired Q format ($Q_{des}$) or other type of bit format is continuously determined and selected based on a modulation type (MT) of the transmission. Optionally, the noise power $\sigma^2$ may be considered as well. In a subsequent optional HARQ stage which consists of a HARQ combiner (HARQ-CB) 40 and a HARQ memory (HARQ-MEM) 42 previously received probability values, i.e., soft bit patterns which are stored in the HARQ memory 42, may be combined with currently received probability values. The previous probability values are stored with a previous Q format ($Q_{prev}$) determined by the modulation type and optionally by the noise power $\sigma^2$ of the previous transmission. At a subsequent decoder (DEC) 50 all received soft values are converted into the most likely transmitted bits, or sequence. An example of this decoder 50 is a turbo decoder.

Fig. 2 shows a schematic block diagram of the soft demodulator 30 according to the first embodiment with a Q format shifting function or unit (QS) 32 adapted to shift the Q format based on the modulation type (MT) of the current transmission. As an example, the soft bit output can be expressed as a function of the received signal z and the noise power $\sigma^2$.

$$LLR_I(b_k) \approx f\left(\frac{z^2}{\sigma^2}\right) \qquad\qquad (3)$$

The actual function f() is determined by the transmission scheme. In a fixed point calculation, both z and $\sigma^2$ may be quantized. To change the Q format of the final output, a shift can be done in the shifting unit 32 (which is equivalent to multiplying or dividing the value of the soft bit pattern by a power of 2).

The operation, in floating point equivalent can be expressed as:

$$fixed\ LLR_I(b_k) \approx round(floating\ LLR\ 2^n) \qquad\qquad (4)$$

where n is the number of bits shifted and the round() function is arbitrary, and includes saturation to ensure the number is correctly represented.

The shift in the shifting unit 32 can be done on any combination of the input value z, noise power $\sigma^2$, or on the final output before saturation. E.g., in a fixed point expression either:

• input z can be shifted (left or right) by a value set by the desired Q format before calculation, or

• Input $\sigma^2$ can be shifted (left or right) by a value set by the desired Q format before calculation, or

• output probability value (e.g. LLR) can be shifted (left or right) by a value set by the desired Q format after calculation, or

• some combination of the above where the final effective shift is set by the desired Q format

For a particular transmission, all received bits should have the same Q format.

Thus, the Q format may be chosen by the modulation type and optionally by at least one of the noise power $\sigma^2$, the output bit width and any other factor.

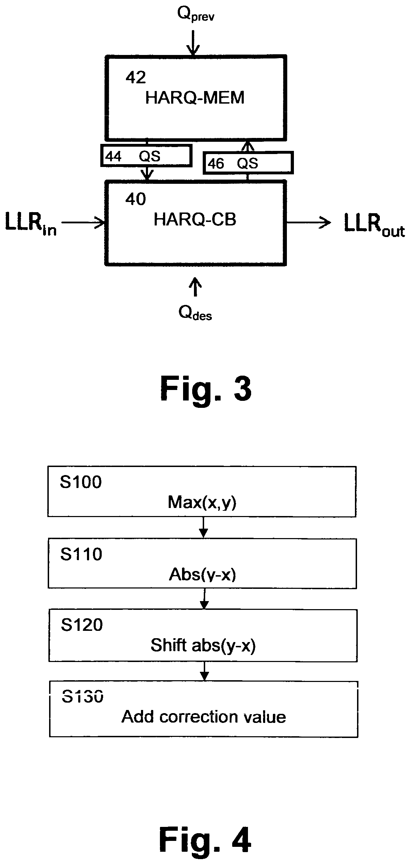

Fig. 3 shows a schematic block diagram of the HARQ stage according to the first embodiment with additional read and write Q shifting functions or units (QS) 44 and 46 for shifting the Q format during a reading or writing operation from/to the HARQ memory 42, respectively. The HARQ combiner 40 is responsible for taking all soft bits in the current transmission, and combining with soft bits from previous transmissions. The combining scheme may include incremental redundancy, chase combining or other techniques.

The basic HARQ combining scheme involves loading the previous soft bit data from the HARQ memory 42, combining it with the current soft bit data of the current transmission, and then storing the new soft bit values back in the HARQ memory 42.

In case of retransmissions, or for other reasons, the Q format ($Q_{prev}$) of the HARQ memory 42 may be different from the current format ($Q_{des}$). E.g., if the first transmission used QAM16, and the next QPSK, the Q format may need to be changed.

According to the first embodiment, to allow combination of different Q formats, a shifting function is added when loading soft bit data from the HARQ memory 42. This can be implemented in the read Q shifting function 44 directly in special hardware by changing the mapping of bits onto a bus connecting the HARQ memory 42 and the HARQ combiner 40, or in software by using a bit shift function.

The amount of shift to be used is the difference in Q formats between the previous transmission and the current transmission. E.g., if the current transmission is using Q2.5, and the previous used Q3.4, the old or previous soft bit pattern should be shifted by one bit to the left.

In addition, if the bit width of the HARQ memory 42 is different from the bit width of the soft demodulator 30 (e.g. to save memory space) the store function can also include a shift function to allow storage in a different Q format. This shift function can be achieved by the write Q shifting unit 46, which is thus an optional unit. E.g., as an example in the case of a digital signal processor (DSP), the soft bit calculations may be done in 8 bit, as it matches the natural number of bits in a byte. However, the HARQ memory may only store 6 bits, in order to save memory, at the cost of some reduction in accuracy.

Decoding of the soft bits at the decoder 50 of Fig. 1 depends on the transmitted codes. Typically, in wireless systems block, convolutional, turbo, or LDPC type codes are used. For example, LTE uses turbo codes for coding the transmitted data. For turbo codes, there are two main types of decoder, based on the BCJR algorithm, max-star and max-log-MAP. The BCJR algorithm is named after the initials of its developers L. Bahl, J. Cocke, F. Jelinek und J. Raviv and is an algorithm for maximum a posteriori decoding of error correcting codes defined on trellises (principally convolutional codes).

The ideal turbo decoder calculates

$$LLR_I(b_k) = \ln \sum\nolimits_{d \in \{b_k = 1\}} P(d \mid z) - \ln \sum\nolimits_{d \in \{b_k = 0\}} P(d \mid z) \tag{5}$$

where P() is a probability function, d is the data sequence corresponding to the current bit being a 1 or 0 respectively, and z are the received values (converted to LLR). Note that this is similar to calculating the LLR of a single bit, however it is conditioned on the entire received sequence. The BCJR algorithm offers an efficient way of calculating these values using an iterative approach in the log domain. This approach requires the summation of values together, and taking a log of the result, e.g., $ln(e^x + e^y)$.

For the max-star algorithm the summation can be approximated as follows:

$$max^*(x,y) = ln(e^x + e^y)$$

$$= max(x,y) + ln(1+e^{-|y-x|})$$

$$= max(x,y) + f_c(-|y - x|) \tag{6}$$

that is, the addition is determined as the maximum of the two values, and a correction value $f_c(-|y - x|)$ which depends on the magnitude of the difference between the two values. The correction value is typically modeled as a lookup table.

The max-log-MAP further approximates this by setting the correction value to zero, e.g. $max^*(x,y) = max(x,y)$. Thus, in the case of the max-log-MAP approach, the Q format does not affect the output, as all the values are relative to cach other.

However for the above max-star approach according to equation (6), the sum is based on the difference between two values, if the Q format changes, then the fixed point difference between two floating point values also changes.

Fig. 4 shows a schematic flow diagram of a modified decoding procedure at the decoder 50 according to a second embodiment.

In the second embodiment which relates to the above max-star approach, the Q format change is compensated when the sum value is calculated as part of the decoding process. According to Fig. 4, the maximum value of x and y is determined in step S100. Then, the absolute value of the difference between y and x is calculated in step S110. In the subsequent step S120 the resulting absolute value is shifted by the difference between the Q format of the input value and the Q format of the lookup-table. Finally, in step S130, the correction value is retrieved from the look-up table and added to the maximum value of step S100 to get the final output value.

E.g., if the input format is Q2.5, and the lookup table had assumed Q3.4, the difference between x and y must be right shifted by 1 before using the lookup table.

The exact steps required depend on the decoder type and algorithm used, but most fixed point implementations use some simplifications, where only a simple shift is required to account for Q format changes.

Of course, there may be other similar approaches for other decoder types.

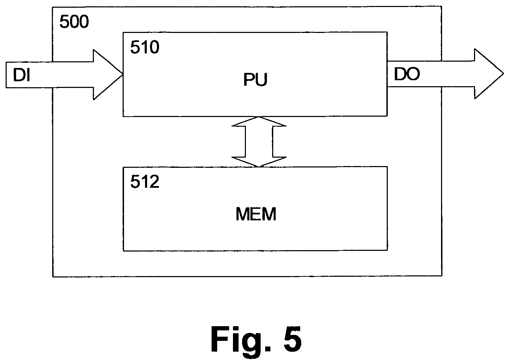

Fig. 5 shows a schematic block diagram of an alternative software-based implementation according to a third embodiment. The required functionalities can be implemented in a computer device 500 with a processing unit 510, which may be any processor or computer device supporting multi-tasking with a control unit which performs control based on software routines of a control program stored in a memory 512. The control program may also be stored separately on a computer-readable medium. Program code instructions are fetch from the memory 512 and are loaded to the control unit of the processing unit 510 in order to perform the functions of the steps or stages of Figs. 1 to 4, (which may be implemented as the above mentioned software routines. The processing steps may be performed on the basis of input data DI and may generate output data DO. In the present interaction system, the input data DI may correspond to a received soft bit value expressing a probability of a bit value, and the output data DO may correspond to the decoded original bit information.

Consequently, the functionalities of the above embodiments may be implemented as a computer program product comprising code means for generating each individual step of the proposed channel estimation when run on a computer device or data processor.

In summary, a method and apparatus for decoding binary information received via a communication channel have been described, wherein values of a received signal are converted into probabilities that a first or second value of the binary information has been received, and wherein a predetermined bit format is used for binary expression of the probabilities. The predetermined bit format is selected per transmission based on a modulation type of the received signal, and the probabilities are converted into most likely transmitted bits based on the selected predetermined bit format.

It is apparent that the invention can easily be extended to any software environment which may include a collection of hardware and software technologies where some or all of the operating functions are implemented through modifiable software or firmware operating on programmable processing technologies. Such devices include field programmable gate arrays (FPGAs), digital signal processors (DSPs), general purpose processors (GPPs), programmable System on Chip (SoC) or other application specific programmable processors. The use of these technologies allows new wireless features and capabilities to be added to existing radio systems without requiring new hardware. Moreover, the invention is not restricted to LTE systems and can be applied to any communication system which requires soft bit decoding. More specifically, the present invention is applicable to any bit format or bit pattern used to express the soft bits or soft value of the probabilities. The embodiments may thus vary within the scope of the attached claims.

## Claims

1. A method of decoding binary information received via a communication channel, said method comprising:

   a) converting (30) values of a received signal into probabilities that a first or second value of said binary information has been received;
   b) using a predetermined bit format for binary expression of said probabilities; and **characterized by**
   c) converting (50) said probabilities into most likely transmitted bits based on said selected predetermined bit format; and
   d) selecting said predetermined bit format per transmission based on a modulation type of said received signal .

2. The method according to claim 1, further comprising expressing said probabilities as fractional fixed point values, wherein said predetermined bit format comprises a first number of bits representing a signed integer of said fractional fixed point value and a second number of bits representing a fraction of said fractional fixed point value.

3. The method according to claim 1 or 2, wherein said probabilities are log likelihood ratios.

4. The method according to any one of the preceding claims, further comprising selecting said predetermined bit format also based on a noise or interference estimate of said communication channel.

5. The method according to any one of the preceding claims, further comprising modifying said predetermined bit format to map a probability of a received value of a current transmission to a stored probability of a received value of a previous transmission.

6. The method according to claim 5, further comprising modifying said predetermined bit format by using a shift function.

7. The method according to any one of the preceding claims, further comprising converting said probabilities to said most likely transmitted bits by applying soft bit combining and shifting a compensation value of said soft bit combining in accordance with said selected predetermined bit format.

8. The method according to any one of the preceding claims, further comprising converting said received values into said probabilities by computing a function of said received value and a received noise power, and by shifting a bit pattern of at least one of said received value, said received noise power and an output value of said function in accordance with said selected predetermined bit format, said function being determined by a transmission scheme of said communication channel.

9. An apparatus for decoding binary information received via a communication channel, said apparatus comprising:

   a) demodulation means (30) for converting values of a received signal into probabilities that a first or second value of said binary information has been received, wherein said demodulation means (30) is adapted to use a predetermined bit format for binary expression of said probabilities; and **characterized by** further comprising
   b) decoding means (50) for converting said probabilities into most likely transmitted bits based on said selected predetermined bit format; and
   c) selection means (30) for selecting said predetermined bit format per transmission based on a modulation type of said received signal.

10. The apparatus according to claim 9, further comprising retransmission combining means (40) for combining probabilities of a current transmission with probabilities of a previous transmission, said retransmission combining means (40) including first bit shifting means (44, 46) for matching the selected bit format of said previous transmission to the selected bit format of said current transmission.

11. The apparatus according to claim 10, wherein said first bit shifting means (32) is adapted to perform said shifting by changing a mapping of bits onto a connection bus or by using a bit shifting process.

12. The apparatus according to any one of claims 9 to 11, wherein said demodulation means (30) is adapted to convert said received value into said probability by computing a function of said received value and a received noise power, and wherein said demodulation means comprises second bit shifting means (32) for shifting a bit pattern of at least one of said received value, said received noise power and an output value of said function in accordance with said selected predetermined bit format, said function being determined by a transmission scheme of said communication channel.

13. The apparatus according to any one of claims 9 to 12, wherein said decoding means (50) is adapted to compensate for a change of said predetermined bit format when calculating a sum value as part of the decoding process.

14. A receiver device comprising an apparatus according to any one of claims 9 to 13.

15. A computer program product comprising code means for producing the steps of any one of claims 1 to 8 when run on a computing device.

**Patentansprüche**

1. Verfahren zum Decodieren von über einen Kommunikationskanal empfangener binärer Information, wobei das Verfahren umfasst:

   a) Konvertieren (30) von Werten eines empfangenen Signals in Wahrscheinlichkeiten, dass ein erster oder zweiter Wert der binären Information empfangen wurde;
   b) Verwenden eines vorbestimmten Bit-Formats zum binären Ausdrücken der Wahrscheinlichkeiten; und
   **gekennzeichnet durch**
   c) Konvertieren (50) der Wahrscheinlichkeiten in am wahrscheinlichsten übertragene Bits basierend auf dem ausgewählten vorbestimmten Bit-Format; und
   d) Auswählen des vorbestimmten Bit-Formats pro Übertragung basierend auf einem Modulationstyp des empfangenen Signals.

2. Verfahren nach Anspruch 1, des Weiteren umfassend ein Ausdrücken der Wahrscheinlichkeiten als Festkomma-Bruchwerte, wobei das vorbestimmte Bit-Format eine erste Anzahl von Bits umfasst, die einen vorzeichenbehafteten Ganzzahlwert des Festkomma-Bruchwertes repräsentieren, und eine zweite Anzahl von Bits, die einen Bruchteil des Festkomma-Bruchwertes repräsentieren.

3. Verfahren nach Anspruch 1 oder 2, wobei die Wahrscheinlichkeiten Log-Wahrscheinlichkeitsverhältnisse sind.

4. Verfahren nach einem der vorangegangenen Ansprüche, des Weiteren umfassend ein Auswählen des vorbestimmten Bit-Formats zusätzlich basierend auf einer Rausch- oder Interferenzschätzung des Kommunikationskanals.

5. Verfahren nach einem der vorangegangenen Ansprüche, des Weiteren umfassend ein Modifizieren des vorbestimmten Bit-Formats, um eine Wahrscheinlichkeit eines empfangenen Wertes einer aktuellen Übertragung auf eine gespeicherte Wahrscheinlichkeit eines empfangenen Wertes einer vorangegangenen Übertragung abzubilden.

6. Verfahren nach Anspruch 5, des Weiteren umfassend ein Modifizieren des vorbestimmten Bit-Formats unter Verwendung einer Shift-Funktion.

7. Verfahren nach einem der vorangegangenen Ansprüche, des Weiteren umfassend ein Konvertieren der Wahrscheinlichkeiten in die am wahrscheinlichsten übertragenen Bits durch Anwenden einer weichen Bit-Kombinierung und eines Shiftens eines Kompensationswertes der weichen Bit-Kombinierung in Übereinstimmung mit dem ausgewählten vorbestimmten Bit-Format.

8. Verfahren nach einem der vorangegangenen Ansprüche, des Weiteren umfassend ein Konvertieren der empfangenen Werte in die Wahrscheinlichkeiten durch Berechnen einer Funktion des empfangenen Wertes und einer empfangenen Rauschleistung, und durch Shiften eines Bit-Musters von zumindest einem von dem empfangenen Wert, der empfangenen Rauschleistung und einem Ausgangswert der Funktion in Übereinstimmung mit dem ausgewählten vorbestimmten Bit-Format, wobei die Funktion durch ein Übertragungsschema des Kommunikationskanals bestimmt ist.

9. Vorrichtung zum Decodieren von über einen Kommunikationskanal empfangener binärer Information, wobei die Vorrichtung umfasst:

a) ein Demodulationsmittel (30) zum Konvertieren von Werten eines empfangenen Signals in Wahrscheinlichkeiten, dass ein erster oder zweiter Wert der binären Information empfangen wurde, wobei das Demodulationsmittel (30) angepasst ist, ein vorbestimmtes Bit-Format zum binären Ausdrücken der Wahrscheinlichkeiten zu verwenden; und
**gekennzeichnet durch** ein weiteres Umfassen von
b) einem Decodiermittel (50) zum Konvertieren der Wahrscheinlichkeiten in am wahrscheinlichsten übertragene Bits basierend auf dem ausgewählten vorbestimmten Bit-Format; und
c) einem Auswahlmittel (30) zum Auswählen des vorbestimmten Bit-Formats pro Übertragung basierend auf einem Modulationstyp des empfangenen Signals.

10. Vorrichtung nach Anspruch 9, des Weiteren umfassend ein Erneute-Übertragung-Kombiniermittel (40) zum Kombinieren von Wahrscheinlichkeiten einer aktuellen Übertragung mit Wahrscheinlichkeiten einer vorangegangenen Übertragung, wobei das Erneute-Übertragung-Kombiniermittel (40) ein erstes Bitshiftmittel (44, 46) zum Abgleichen des ausgewählten Bit-Formats der vorangegangenen Übertragung mit dem ausgewählten Bit-Format der aktuellen Übertragung beinhaltet.

11. Vorrichtung nach Anspruch 10, wobei das erste Bitshiftmittel (32) angepasst ist, das Shiften durch Ändern einer Abbildung von Bits auf einen Verbindungsbus oder durch Verwenden eines Bitshift-Prozesses durchzuführen.

12. Vorrichtung nach einem der Ansprüche 9 bis 11, wobei das Demodulationsmittel (30) angepasst ist, den empfangenen Wert in die Wahrscheinlichkeit zu konvertieren durch Berechnen einer Funktion des empfangenen Wertes und einer empfangenen Rauschleistung, und wobei das Demodulationsmittel ein zweites Bitshiftmittel (32) zum Shiften eines Bit-Musters von zumindest einem von dem empfangenen Wert, der empfangenen Rauschleistung und einem Ausgabewert der Funktion in Übereinstimmung mit dem ausgewählten vorbestimmten Bit-Format umfasst, wobei die Funktion durch ein Übertragungsschema des Kommunikationskanals bestimmt ist.

13. Vorrichtung nach einem der Ansprüche 9 bis 12, wobei das Decodiermittel (50) angepasst ist, für eine Änderung des vorbestimmten Bit-Formats zu kompensieren, wenn ein Summenwert als Teil des Decodiervorgangs berechnet wird.

14. Empfängergerät, umfassend eine Vorrichtung nach einem der Ansprüche 9 bis 13.

**15.** Computerprogrammprodukt, umfassend Codiermittel zum Erzeugen der Schritte nach einem der Ansprüche 1 bis 8, wenn sie auf einem Computergerät ausgeführt werden.

**Revendications**

**1.** Procédé de décodage d'une information binaire reçue par l'intermédiaire d'un canal de communication, procédé dans lequel :

a) on transforme (30) des valeurs d'un signal reçu en des probabilités qu'une première ou une deuxième valeur de l'information binaire a été reçue ;
b) on utilise une disposition de bit déterminée à l'avance pour une expression binaire des probabilités et **caractérisé par**
c) on transforme (50) les probabilités en des bits transmis le plus probablement sur la base de la disposition de bit sélectionnée déterminée à l'avance et
d) on sélectionne la disposition de bit déterminée à l'avance par transmission sur la base d'un type de modulation du signal reçu.

**2.** Procédé suivant la revendication 1, dans lequel en outre on exprime les probabilités sous la forme de valeurs fractionnelles à virgule fixée, la disposition de bit déterminée à l'avance comprenant un premier nombre de bits représentant un nombre entier relatif de la valeur fractionnelle à virgule fixée et un deuxième nombre de bits représentant une fraction de la valeur fractionnelle à virgule fixée.

**3.** Procédé suivant la revendication 1 ou 2, dans lequel les probabilités sont des rapports logarithmiques de vraisemblance.

**4.** Procédé suivant l'une quelconque des revendications précédentes, dans lequel en outre on sélectionne la disposition de bit déterminée à l'avance, sur la base aussi d'une estimation de bruit ou d'interférence du canal de communication.

**5.** Procédé suivant l'une quelconque des revendications précédentes, dans lequel en outre on modifie la disposition de bit déterminée à l'avance, pour faire correspondre une probabilité d'une valeur reçue d'une transmission en cours à une probabilité mémorisée d'une valeur reçue d'une transmission précédente.

**6.** Procédé suivant la revendication 5, dans lequel en outre on modifie la disposition de bit déterminée à l'avance en utilisant une fonction de décalage.

**7.** Procédé suivant l'une quelconque des revendications précédentes, dans lequel en outre on transforme les probabilités en les bits transmis le plus probablement, en appliquant une combinaison de bits souple et en décalant une valeur de compensation de la combinaison de bits souple en fonction de la disposition de bit sélectionnée déterminée à l'avance.

**8.** Procédé suivant l'une quelconque des revendications précédentes, dans lequel en outre on transforme les valeurs reçues en les probabilités, en calculant une fonction de la valeur reçue et d'une puissance de bruit reçue et en décalant une configuration de bit d'au moins un de la valeur reçue, de la puissance de bruit reçue et d'une valeur de sortie de la fonction en fonction de la disposition de bit sélectionnée déterminée à l'avance, la fonction étant déterminée par un plan de transmission du canal de communication.

**9.** Dispositif de décodage d'une information binaire reçue par l'intermédiaire d'un canal de communication, le dispositif comprenant :

a) des moyens (30) de démodulation pour transformer des valeurs d'un signal reçu en des probabilités qu'une première ou qu'une deuxième valeur de l'information binaire a été reçue, les moyens (30) de démodulation étant conçus pour utiliser une disposition de bits déterminée à l'avance pour une expression binaire des probabilités et **caractérisé en ce qu'**il comprend en outre
b) des moyens (50) de décodage pour transformer des probabilités en des bits transmis le plus probablement sur la base de la disposition de bit sélectionnée déterminée à l'avance et
c) des moyens (30) de sélection pour sélectionner la disposition de bits déterminée à l'avance par transmission sur la base d'un type de modulation du signal reçu.

**10.** Appareil suivant la revendication 9, comprenant en outre des moyens (40) de combinaison de retransmission pour combiner des probabilités d'une transmission en cours à des probabilités d'une transmission précédente, les moyens (40) de combinaison de retransmission comprenant des premiers moyens (44, 46) de décalage de bit pour faire correspondre la disposition de bit sélectionnée de la transmission précédente à la disposition de bit sélectionnée de la transmission en cours.

**11.** Appareil suivant la revendication 10, dans lequel les premiers moyens (32) de décalage de bit sont conçus pour effectuer le décalage en changeant une correspondance de bits sur un bus de connexion ou en utilisant une opération de décalage de bit.

**12.** Appareil suivant l'une quelconque des revendications 9 à 11, dans lequel les moyens (30) de démodulation sont conçus pour transformer la valeur reçue en la probabilité en calculant une fonction de la valeur reçue et une puissance de bruit reçue et dans lequel les moyens de démodulation comprennent des deuxièmes moyens (32) de décalage de bit pour décaler une configuration de bit d'au moins un de la valeur reçue, de la puissance de bruit reçue et d'une valeur de sortie de la fonction, en fonction de la disposition de bit sélectionnée déterminée à l'avance, la fonction étant déterminée par un plan de transmission du canal de communication.

**13.** Appareil suivant l'une quelconque des revendications 9 à 12, dans lequel les moyens (50) de décodage sont conçus pour compenser un changement de la disposition de bit déterminée à l'avance lorsque l'on calcule une valeur de somme comme partie de l'opération de décodage.

**14.** Dispositif récepteur comprenant un dispositif suivant l'une quelconque des revendications 9 à 13.

**15.** Produit de programme d'ordinateur comprenant des moyens de code pour produire les stades de l'une quelconque des revendications 1 à 8 lorsqu'ils passent sur un dispositif informatique.

**Fig. 1**

**Fig. 2**

Q_prev

## 42
HARQ-MEM

44   QS          46   QS

LLR_in →   ## 40
HARQ-CB   → LLR_out

Q_des

# Fig. 3

S100
Max(x,y)

S110
Abs(y-x)

S120
Shift abs(y-x)

S130
Add correction value

# Fig. 4

**Fig. 5**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6986096 B2
- US 20090185644 A1
- US 20050025076 A1
- US 20090061875 A1

**Non-patent literature cited in the description**

- **F.U. DOWLA.** Handbook of RF and Wireless Technologies. 2003